# FASCICULE DE BREVET EUROPEEN

(11) **EP 2 241 997 B1**
(45) Date de publication et mention de la délivrance du brevet: **11.04.2012**
(21) Numéro de dépôt: 10159587.4
(22) Date de dépôt: 12.04.2010
(51) Int. Cl.: G06K 7/00

(54) **Lecteur de carte mémoire**
Speicherkartenleser
Memory card reader

(30) Priorité: 15.04.2009 FR 0952476
(43) Date de publication de la demande: 20.10.2010
(73) Titulaire: Compagnie Industrielle et Financière d'Ingénierie "Ingenico", 92200 Neuilly sur Seine (FR)
(72) Inventeur: Lambert, Xavier, 92500, RUEIL MALMAISON (FR); De Sa Costa, Sylvain, 26000, VALENCE (FR); Vassy, Lilian, 26140, ALBON (FR)
(74) Mandataire: Le Saux, Gaël

(56) Documents cités:
- EP-A- 0 256 778
- FR-A- 2 875 036
- US-A1- 2008 156 521

## Description

### 1 DOMAINE DE L'INVENTION

La présente invention se rapporte au domaine de la protection des dispositifs de lecture de cartes mémoire. De tels dispositifs de lecture de carte mémoire sont employés dans de nombreux appareils tels que des terminaux de paiement, des dispositifs d'authentification ou d'identification ou encore des dispositifs de lecture de contenus.

La présente invention se rapporte plus particulièrement à la sécurisation de tels dispositifs de lecture de cartes mémoire afin qu'il ne soit pas possible de capter ou de surveiller des signaux qui sont échangés entre une carte mémoire insérée dans le dispositif et un processeur sécurisé qui traite des données issues de cette carte mémoire.

### 2 ART ANTERIEUR

Les appareils qui intègrent des dispositifs de lecture de carte mémoire, tels que des terminaux de paiement, comprennent de nombreux dispositifs de sécurisation et mettent en oeuvre de nombreuses méthodes permettant d'assurer que les appareils sont utilisés conformément aux usages pour lesquels ils ont été prévus et respectent des normes de sécurité qui sont imposés par des organismes de certification.

Par exemple, dans le domaine des terminaux de paiement pour cartes à puces, les fabricants sont contraints de respecter depuis de 1er Janvier 2008, la norme PCI PED 2.0 (Payment Card Industry Pin Entry Device).

Cette nouvelle norme sécuritaire consiste notamment à sécuriser le clavier de saisie des terminaux en protégeant la saisie du code confidentiel, et à bloquer le terminal en cas d'intrusion (frauduleuse ou accidentelle).

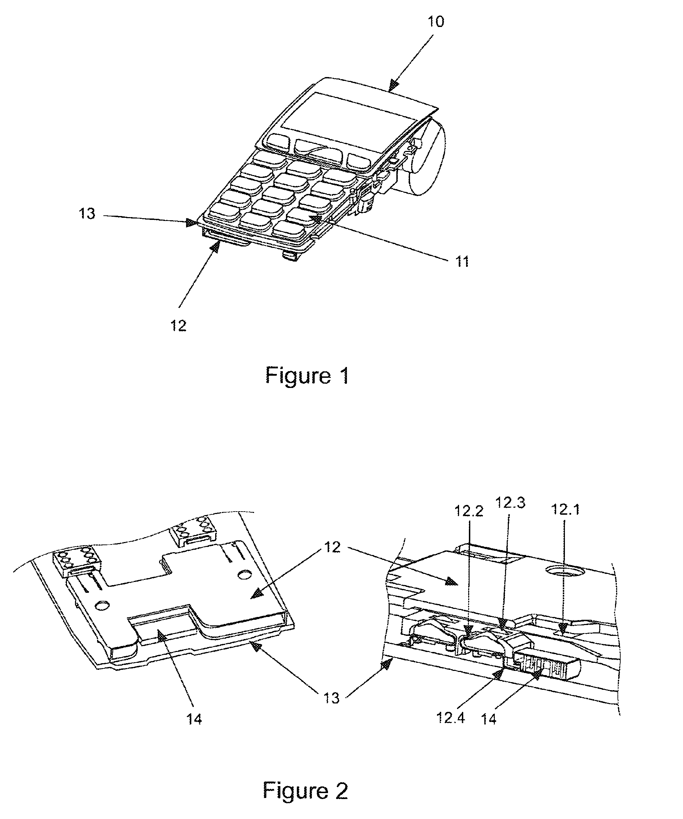

On présente, en relation avec la figure 1, un terminal de paiement. De part sa constitution un tel terminal de paiement (10) présente généralement :
- un clavier (11) sur sa face supérieure ;
- un connecteur de carte à mémoire (12) parfois placé sous le clavier et qui permet d'introduire la carte et de dialoguer avec elle. Ce connecteur de carte à mémoire (12) est fixé, généralement par soudure, à un circuit imprimé (13).

Afin de protéger le terminal il a parfois été jugé intéressant de combiner les sécurités sur ces deux organes. Une première protection consiste à rapporter un circuit treillis de protection du connecteur carte à mémoire autour de celui-ci et de relier ce circuit treillis électriquement à la carte électronique par l'intermédiaire de soudures qui ne sont pas accessibles sans enlever le clavier. Or le clavier est lui-même protégé d'un démontage frauduleux par la présence de fausses touches qui détectent le retrait de celui-ci. De ce fait, une protection simple (par exemple avec un circuit treillis sur une seule face d'un circuit imprimé souple), pourvu qu'elle soit connectée en des points inaccessibles par un fraudeur peut suffire à protéger quatre faces sur cinq du connecteur de carte à mémoire (CAM).

La dernière face servant à l'introduction de la carte du client ne peut bien sûr pas être fermée. Il reste donc, dans ce cas précis, un angle d'attaque au fraudeur pour atteindre des points de contact (pins) du connecteur, et notamment les points de contacts par lesquels transitent les signaux d'entrées/sorties (dits I/O).

En effet, le connecteur de carte à mémoire de part son implantation sur le circuit imprimé définit trois zones :
- une zone principale de connexion avec la carte mémoire qui permet de lire les informations présentes sur la carte ;
- une zone de liaison qui est noyée dans le connecteur de carte à mémoire ;
- une zone intermédiaire dans laquelle les points de contact sont reliés au circuit imprimé.

Il était nécessaire de se prémunir d'un accès frauduleux à ces points de contact. En effet, il est fort possible d'imaginer connecter, au niveau de ces points de contact, un dispositif de surveillance qui pourrait être utilisé pour enregistrer les signaux qui transiteraient entre le processeur et la carte à puce. Un tel enregistrement pourrait conduire à une obtention de données sensibles. On doit donc protéger ces points de contact, au niveau de la zone intermédiaire, par un système n'interférant pas avec la fonctionnalité du connecteur de carte à mémoire.

Une telle sécurisation est réalisée à l'aide de plusieurs technologies matérielles et logicielles.

Au niveau matériel, certains constructeurs ont directement intégrés un cache au niveau du connecteur de carte à mémoire. Selon les constructeurs, ce cache est fixe ou amovible. Lorsqu'il est amovible, ce cache est monté pivotant pour permettre une maintenance de l'appareil bien qu'il le mette hors service (le pivot permet d'être "sensible" pour déclencher une procédure de sécurisation lorsque l'on veut y accéder). L'appareil reste réparable par une personne habilitée (perte des informations sensibles, telles que les informations bancaires). C'est cependant une solution onéreuse qui nécessite une opération d'activation. Lorsqu'il est monté fixe sur le connecteur de carte à mémoire ou lorsque ce cache fait intégralement partie du connecteur de carte à mémoire, il n'est généralement pas possible d'intervenir sur le connecteur de carte à mémoire pour réaliser une maintenance de l'appareil. Il faut alors remplacer l'intégralité du connecteur de carte à mémoire. De plus, ces connecteurs nécessitent une étape supplémentaire pour activer la protection (opération mécanique).

De plus, dans les solutions de l'art antérieur, les caches sont généralement constitués d'une pièce en plastique ou en matériau résistant et d'un élément conducteur tel qu'un fil de cuivre. Or la fabrication d'un tel cache, qui ne mesure pas plus de quelques millimètres, en intégrant à la fois des éléments non conducteurs et des éléments conducteurs est complexe.

Il était donc nécessaire de trouver une solution de protection simple et peu coûteuse et qui permettent de réaliser une maintenance de l'appareil sans rendre celui-ci inutilisable. « suite page 3a»

### 3 RESUME DE L'INVENTION

L'invention ne présente pas les inconvénients de l'art antérieur. En effet, l'invention concerne un Lecteur de carte à mémoire, comprenant un circuit imprimé sur lequel est monté un connecteur de carte à mémoire, ledit connecteur

Le document « *ITT MFG ENTREPRISES* », (FR 2 875 036) du 10 mars 2006 porte sur un connecteur de carte à mémoire comprenant un dispositif anti-intrusion (page 1, ligne 5 à 10) qui se présente sous la forme d'une cage métallique (isolée) qui entoure un connecteur spécifique à protéger (22, 38). Selon ce document, le connecteur de carte à mémoire comporte au moins une lame de contact de signal (22a) et une lame de contact de masse et comportant au moins une plaque métallique (42, 50) de protection qui s'étend en regard d'une portion en vis-à-vis de la première lame de contact de signal et qui est reliée électriquement à une lame de contact de masse. de carte à mémoire présentant une fente destinée à introduire une carte mémoire et un ensemble de points de contact permettant un échange de données entre ladite carte à mémoire et un processeur monté sur ledit circuit imprimé.

Selon l'invention, ledit circuit imprimé porte en outre un dispositif anti-intrusion formé et placé de sorte que ledit dispositif anti-intrusion empêche l'accès, à partir de l'extérieur dudit lecteur, à au moins une portion de connexion entre au moins un desdits points de contact dudit ensemble de points de contact et ledit circuit imprimé.

Ainsi, il n'est pas possible d'accéder aux pins du connecteur pour obtenir, de manière frauduleuse, les signaux qui transitent entre la carte à mémoire et le processeur. En effet, là où les dispositifs de l'art antérieur proposaient des solutions consistant à masquer les pins directement au niveau des connecteurs de carte à mémoire, par exemple en proposant un cache en plastique, l'invention propose une solution basée sur la fixation directement sur le circuit imprimé, d'un dispositif anti-intrusion spécifiquement adapté à la fonction de cache des points de contact du connecteur de cartes à mémoire. L'invention apporte ainsi une solution simple à mettre en oeuvre et peu coûteuse puisqu'il suffit de monter et de fixer le dispositif anti-intrusion à l'endroit idoine. Cette opération peut même être réalisée après le montage du connecteur de carte à mémoire, par exemple en utilisant un procédé de report de composants sur des circuits imprimés en procédé sans plomb.

Selon un mode de réalisation particulier de l'invention, ledit dispositif anti-intrusion a sensiblement la forme d'un parallélépipède rectangle comprenant, en sa face supérieure, une protubérance d'obstruction de l'accès auxdits points de contact par le dessus dudit dispositif anti-intrusion. Le dispositif anti-intrusion est, selon l'invention, réalisé selon les techniques de fabrication des circuits imprimés.

Selon un mode de réalisation particulier de l'invention, ledit dispositif anti-intrusion comprend au moins un circuit conducteur tridimensionnel et au moins deux éléments de contact dudit circuit conducteur avec une plage de connexion dudit dispositif anti-intrusion sur ledit circuit imprimé ;

Ainsi, le dispositif anti-intrusion est inviolable, car une effraction de celui-ci entraîne un court circuit dans le treillis qu'il comprend, déclenchant ainsi une action au niveau du processeur sécuritaire

Selon un mode de réalisation particulier de l'invention, ledit circuit imprimé comprend une zone destinée à recevoir ledit dispositif anti-intrusion laquelle comprend un nombre pair de plages de connexion dudit dispositif anti-intrusion.

Ainsi, lors d'une opération de microfixation, telle qu'une soudure, dudit dispositif anti-intrusion sur ledit circuit imprimé, les forces de mouillage s'exercent de manière uniforme entre ledit dispositif anti-intrusion et ledit circuit imprimé de sorte que ledit CMS ne subit pas de flottement (mouvement, déplacement) lors de la fixation.

Selon une caractéristique particulière de l'invention, lesdites plages sont constituées d'au moins deux parties séparées un espace permettant, lors de la fixation dudit dispositif anti-intrusion sur ledit circuit imprimé, une évacuation d'air qui résulte de ladite fixation.

L'invention concerne également un dispositif de saisie de code confidentiel.

Selon l'invention, un tel dispositif comprend un lecteur de carte mémoire tel que décrit précédemment.

L'invention concerne encore un dispositif anti-intrusion, notamment pour lecteur de carte à mémoire. Selon l'invention, un tel dispositif comprend plusieurs couches de circuit imprimé superposées et reliées entre elles à l'aide de vias enterrées et en ce qu'il se présente sous la forme d'un composant électronique apte à être connecté électriquement à un circuit imprimé sur lequel il est monté.

Selon un autre aspect, l'invention concerne un procédé de sécurisation d'un composant électronique monté sur un circuit imprimé. Selon l'invention, un tel procédé comprend une étape de posage, conjointement audit composant électronique à sécuriser, d'un dispositif anti-intrusion comprenant plusieurs couches de circuit imprimé superposées et reliées entre elles à l'aide de vias enterrées apte à être connecté électriquement à un circuit imprimé sur lequel il est monté.

### 4 LISTE DES FIGURES

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1, déjà commentée, présente une vue globale d'un terminal de paiement intégrant un lecteur de carte à mémoire ;
- la figure 2 illustre un lecteur de carte à mémoire selon l'invention ;
- la figure 3 décrit un dispositif anti-intrusion selon l'invention ;
- la figure 4 décrit un circuit imprimé comprenant des plages de fixation selon l'invention ;
- la figure 5 décrit une plage de fixation selon l'invention.

### 5 DESCRIPTION DETAILLEE DE L'INVENTION

### 5.1 Rappel du principe de l'invention

L'invention propose de protéger frontalement les points de contacts du connecteur de carte à mémoire en adjoignant, sur le circuit imprimé, un dispositif anti-intrusion. Comme le dispositif anti-intrusion est monté sur le circuit imprimé, et non pas sur le connecteur de carte à mémoire, il est plus simple à monter. De plus, il est plus aisé de construire un dispositif anti-intrusion qui soit directement monté sur le circuit imprimé que de construire un dispositif anti-intrusion qui doive être intégré au connecteur de carte à mémoire lui-même.

Selon l'invention, le dispositif anti-intrusion est un composant électronique monté en surface (CMS). Ainsi, le dispositif anti-intrusion peut être monté, sur le circuit imprimé, en même temps que les autres composants dans la même phase de fabrication que les autres composants (l'ordre de posage étant défini lors de la conception de l'appareil).

Dans un mode de réalisation de l'invention, il est envisagé que le dispositif anti-intrusion de l'invention puisse être conformé afin de recevoir, en son sein, un circuit électronique à protéger, formant ainsi une enceinte protectrice à l'intérieure de laquelle peut se trouver un circuit électronique sensible que l'on souhaite protéger. Ainsi, le dispositif anti-intrusion de l'invention peut être utilisé non seulement pour protéger des points de contacts, tels que des points de contact d'entrée/sortie, mais également des circuits imprimés dans leur intégralité, en empêchant ainsi une quelconque tentative de surveillance, par exemple d'un processeur se trouvant au sein du dispositif.

En effet, selon l'invention, le dispositif anti-intrusion comprend plusieurs couches de circuit imprimé superposées et reliées entre elles à l'aide de vias enterrées et en ce qu'il se présente sous la forme d'un composant électronique. Un tel dispositif peut se présenter sous n'importe quelle forme. La forme du dispositif peut être adaptée en fonction du composant ou du circuit imprimé à protéger.

Selon l'invention, on réalise une protection d'un composant électronique monté sur un circuit imprimé en réalisant une étape de posage, conjointement au composant électronique à sécuriser, d'un dispositif anti-intrusion. Lorsque le dispositif anti-intrusion forme une enceinte protectrice, cette étape de posage conjointe assure qu'il n'est pas possible d'altérer le composant électronique à sécuriser.

Par la suite, on présente un mode de réalisation d'un dispositif lecteur de carte à mémoire selon l'invention. Il est clair cependant que l'invention ne se limite pas à cette application particulière, mais peut également être mise en oeuvre dans de nombreux autres contextes de protection de circuits électroniques et plus généralement dans tous les cas où les caractéristiques listées par la suite sont intéressantes.

### 5.2 Description d'un mode de réalisation

On présente dans ce mode de réalisation, un lecteur de carte mémoire selon l'invention dans lequel un dispositif anti-intrusion a été monté sur le circuit imprimé afin d'interdire l'accès aux points de contact, dont le point de contact dit « IO » (de l'anglais pour « Input/output »).

Comme illustré en figure 2, le connecteur de carte à mémoire (12) est monté sur le circuit imprimé (13). Le connecteur de carte à mémoire présente une fente (12.1) dans laquelle la carte peut être introduite. Le connecteur de carte à mémoire comprend également un ensemble de contacts (12.2) permettant une connexion de la carte, une fois que celle-ci est insérée, avec un processeur de l'appareil.

Ces contacts (12.2) présentent un léger renflement (12.3) au niveau de la zone de connexion avec la carte, au sein du connecteur de carte à mémoire. Les contacts sont ensuite conformés pour qu'ils s'étendent vers le circuit imprimé (13). Ils rejoignent celui-ci au niveau d'une zone intermédiaire dans laquelle les points de contact (12.4) sont reliés au circuit imprimé (13).

Le dispositif anti-intrusion (14) est monté de sorte qu'il empêche l'accès à au moins certains points de contact et notamment au contact « IO ».

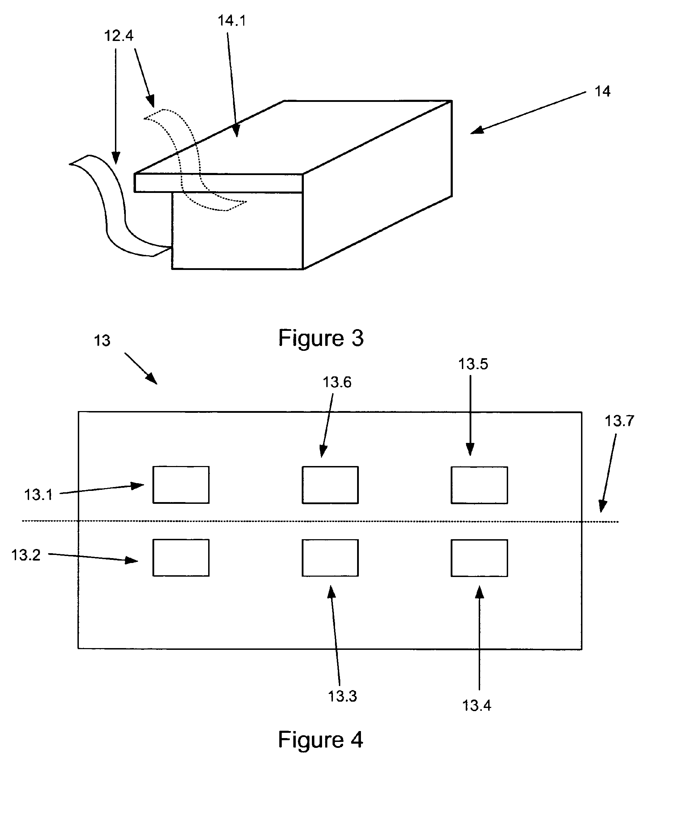

Afin de se prémunir d'un accès aux points de contact par la face supérieure du dispositif anti-intrusion (14), ce dernier peut avantageusement comprendre une protubérance d'obstruction (14.1), qui est un élément dont la largeur ou la longueur est supérieure respectivement à la largeur ou à la longueur du corps du dispositif anti-intrusion et qui sert à masquer les points de contact (12.4) du connecteur de carte à mémoire, comme présenté en figure 3.

Ainsi, il n'est pas possible de faire passer des éléments de contact (tels que des minces fils électriques ou des minces films conducteurs) vers les éléments de contact du connecteur de carte à mémoire afin d'espionner les signaux échangés entre la carte à mémoire et le processeur.

Afin de se prémunir du perçage du dispositif anti-intrusion en vue d'atteindre les points de contacts, le dispositif anti-intrusion comprend au moins un circuit conducteur tridimensionnel et au moins deux éléments permettant le contact du circuit conducteur tridimensionnel avec une plage de connexion du dispositif anti-intrusion sur le circuit imprimé. Plus particulièrement, le dispositif anti-intrusion est appelé treillis puisque le circuit conducteur qu'il contient réalise un quadrillage tridimensionnel du volume du dispositif anti-intrusion.

Un tel quadrillage est réalisé, selon l'invention, en positionnant les unes par-dessus les autres plusieurs couches de circuit imprimé conformément aux technologies classiques de façon à former un dispositif anti-intrusion dont le volume permet de protéger l'accès aux points de contact.

Afin de permettre aux pistes des membranes d'entrer en contact et de former ainsi un véritable circuit tridimensionnel, des vias enterrées sont réalisés entre deux couches successives. Pour mémoire, un via est un trou métallisé qui est destiné à connecter électriquement des différentes couches du circuit imprimé.

Ainsi, on dispose d'un circuit électrique tridimensionnel dont l'architecture est telle qu'il n'est pas envisageable de le percer sans provoquer un court-circuit et déclencher, selon l'invention une protection active de l'appareil, à savoir par exemple un effacement définitif des mémoires contenant des informations sensibles, que ces mémoires soient situées sur l'appareil lui-même ou sur la carte qui y est insérée.

Une fois formé, le dispositif anti-intrusion peut également être à nouveau recouvert d'une membrane et constituer ainsi un composant monté en surface qui intègre lui-même un composant monté en surface.

Selon l'invention, et comme illustré en figure 4, le dispositif anti-intrusion 14 est monté sur le circuit imprimé 13. Pour ce faire, le circuit imprimé dispose, comme à l'accoutumée, de plages (13.1 à 13.6) qui permettent la mise en contact du ou des circuits conducteur du dispositif anti-intrusion avec le ou les circuits du circuit imprimé. Cependant, selon l'invention, le circuit imprimé dispose, dans la zone de montage du dispositif anti-intrusion, d'un nombre pair de plages de mise en contact, les plages étant disposées symétriquement le long d'un axe imaginaire de positionnement (13.7).

En effet, les inventeurs ont remarqué que lors de la fixation des composants montés en surface sur le circuit imprimé, une force latérale est exercée au niveau du composant monté en surface provoquant sa rotation. Les inventeurs ont découvert qu'une des variables qui détermine le degré de rotation du composant monté en surface une fois fixé par rapport à la position de montage de ce même composant est le nombre de plages de fixation et leurs positions les unes par rapport aux autres. Ainsi, les inventeurs ont découvert que une fois monté, lors de l'action des agents de fixations, le composant à tendance à adopter une position symétrique par rapport aux plages de fixation.

Or dans le cadre de l'invention, il est important que la position dans laquelle le dispositif anti-intrusion est fixé soit la position dans laquelle le dispositif anti-intrusion est monté. En effet, si une fois fixé, le dispositif anti-intrusion est incliné ne serait-ce que de quelques degré par rapport à sa position de montage, son action de protection peut être réduite, voire totalement annulée.

Les inventeurs ont donc eu l'idée de placer un nombre pair de plages de fixation pour le dispositif anti-intrusions, ces plages étant réparties symétriquement le long d'un axe de positionnement. Ainsi, les forces qui s'exercent lors de la fixation sont identiques sur toutes les plages et le composant est fixé dans la même position que celle dans laquelle il a été monté.

A la suite de tests, les inventeurs ont également remarqué que la phase de fixation du dispositif anti-intrusion sur le circuit imprimé pouvait conduire à la formation de minuscules poches d'air dans la soudure. Or, de telles poches ne sont pas acceptables dans le cadre de la protection des points de contact. En effet, si une poche d'air est formée lors de la soudure, il pourrait être envisageable d'y introduire une minuscule électrode, par perçage, sans qu'un court circuit ne soit réalisé, et par voie de conséquence, sans que les procédures de sécurisation de l'appareil ne soient mises en place. De plus ces poches d'air sont très dommageables à la résistance mécanique, et peuvent même créer des fausses soudures.

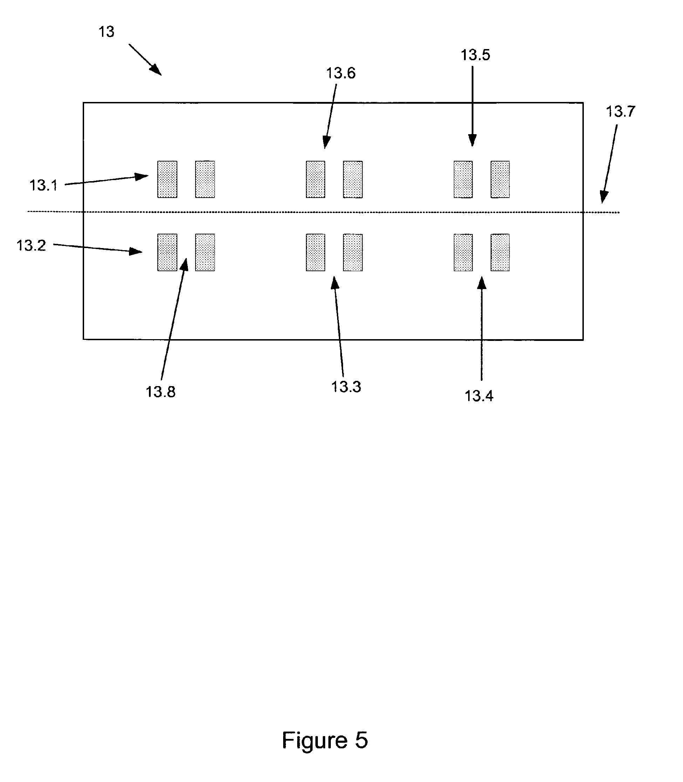

Ainsi, selon l'invention, en relation avec la figure 5, les plages de réception (13.1 à 13.6) ont été séparées par un espace (13.8) ne comprenant pas de cuivre. De ce fait, l'espace laissé libre sur la plage permet de recevoir l'air qui est issu de la fixation et de fournir une soudure parfaitement exempte de poche d'air. Des pistes de garde sont également positionnées autour de chaque soudure 13.1 à 13.6. Ces pistes de garde permettent d'éviter un court circuit des points de contact en réalisant une attaque latérale. Ces pistes de garde ont la forme d'un rectangle qui entoure les plages de réception et qui sont connectées électriquement au processeur sécurisé afin que ce dernier puisse détecter un court circuit.

## Revendications

1. Lecteur de carte à mémoire (10), comprenant un circuit imprimé (13) sur lequel est monté un connecteur de carte à mémoire (12), ledit connecteur de carte à mémoire présentant une fente (12.1), destinée à introduire une carte mémoire et un ensemble de points de contact (12.2), permettant un échange de données entre ladite carte à mémoire et un processeur monté sur ledit circuit imprimé, **caractérisé en ce que** ledit circuit imprimé porte en outre un dispositif anti-intrusion (14) formé et fixé sur ledit circuit imprimé de sorte que ledit dispositif anti-intrusion empêche l'accès, à partir de l'extérieur dudit lecteur, à au moins une portion de connexion entre au moins un desdits points de contact dudit ensemble de points de contact et ledit circuit imprimé.

2. Lecteur de carte à mémoire selon la revendication 1, **caractérisé en ce que** ledit dispositif anti-intrusion a sensiblement la forme d'un parallélépipède rectangle comprenant, en sa face supérieure, une protubérance d'obstruction (14.1) de l'accès auxdits points de contact par le dessus dudit dispositif anti-intrusion.

3. Lecteur de carte à mémoire selon la revendication 1, **caractérisé en ce que** ledit dispositif anti-intrusion comprend au moins un circuit conducteur tridimensionnel et au moins deux éléments de contact dudit circuit conducteur avec une plage de connexion dudit dispositif anti-intrusion sur ledit circuit imprimé.

4. Lecteur de carte à mémoire selon la revendication 1, **caractérisé en ce que** ledit circuit imprimé comprend une zone destinée à recevoir ledit dispositif anti-intrusion laquelle comprend un nombre pair de plages de connexion dudit dispositif anti-intrusion.

5. Lecteur de carte à mémoire selon la revendication 4, **caractérisé en ce que** lesdites plages sont constituées d'au moins deux parties séparées un espace permettant, lors de la fixation dudit dispositif anti-intrusion sur ledit circuit imprimé, une évacuation d'air qui résulte de ladite fixation.

6. Dispositif de saisie de code confidentiel, **caractérisé en ce qu'**il comprend un lecteur de carte mémoire selon la revendication 1.

7. Dispositif anti-intrusion pour lecteur de carte à mémoire selon l'une quelconque des revendications 1 à 6, **caractérisé en ce qu'**il comprend plusieurs couches de circuit imprimé superposées et reliées entre elles à l'aide de vias enterrées et **en ce qu'**il se présente sous la forme d'un composant électronique apte à être connecté électriquement à un circuit imprimé sur lequel il est fixé.

8. Procédé de sécurisation d'un composant électronique monté sur un circuit imprimé **caractérisé en ce qu'**il comprend une étape de fixation, conjointement audit composant électronique à sécuriser, d'un dispositif anti-intrusion, selon la revendication 7, comprenant plusieurs couches de circuit imprimé superposées et reliées entre elles à l'aide de vias enterrées apte à être connecté électriquement à un circuit imprimé sur lequel il est fixé.

## Claims

1. Memory card reader comprising a printed circuit on which a memory card connector is mounted, said memory card connector having a slot intended for inserting a memory card and a set of contact points enabling data exchange between said memory card and a processor mounted on said printed circuit, **characterized in that** said printed circuit is further equipped with an anti-intrusion device formed and positioned such that said anti-intrusion device prevents access, from the exterior of said reader, to at least one connection portion between at least one of said contact points of said set of contact points and said printed circuit.

2. Memory card reader of claim 1, **characterized in that** said anti-intrusion device is substantially in the shape of rectangular parallelepiped which, on the upper face thereof, comprises a protuberance obstructing access to said contact points via the upper part of said anti-intrusion device.

3. Memory card reader of claim 1, **characterized in that** said anti-intrusion device includes at least one three-dimensional conducting circuit and at least two contact elements of said conducting circuit with a connector area of said anti-intrusion device on said printed circuit.

4. Memory card reader of claim 1, **characterized in that** said printed circuit includes a region intended to receive said anti-intrusion device, which includes an even number of connector areas of said anti-intrusion device.

5. Memory card reader of claim 4, **characterized in that** said areas consist of at least two separate portions, while, during the attachment of said anti-intrusion device onto said printed circuit, a space enables air resulting from said attachment to be discharged.

6. PIN code inputting device, **characterized in that** it includes a memory card reader of claim 1.

7. Anti-intrusion device, for a memory card reader as claimed in any of claims 1 to 6, **characterized in that** it includes several superimposed layers of printed circuit which are interconnected by means of embedded vias, and **in that** it is in the form of an electronic component capable of being electrically connected to a printed circuit on which it is mounted.

8. Method of securing an electronic component mounted on a printed circuit, **characterized in that** it includes a step of installing, simultaneously with said electronic component being secured, an anti-intrusion device of claim 7, comprising several superimposed layer of printed circuit which are interconnected by means of embedded vias, and capable of being electrically connected to a printed circuit on which it is mounted.

## Patentansprüche

1. Speicherkartenleser (10), der eine gedruckte Schaltung (13) umfasst, auf der ein Speicherkartenanschluss (12) angebracht ist, wobei der Speicherkartenanschluss einen Schlitz (12.1), der zum Einführen einer Speicherkarte bestimmt ist, und eine Menge von Kontaktpunkten (12.2) aufweist, die einen Datenaustausch zwischen der Speicherkarte und einem Prozessor ermöglichen, der auf der gedruckten Schaltung angebracht ist, **dadurch gekennzeichnet, dass** die gedruckte Schaltung ferner eine Vorrichtung (14) zum Schutz gegen Eindringen trägt, die derart auf der gedruckten Schaltung gebildet und befestigt ist, dass die Vorrichtung zum Schutz gegen Eindringen den Zugang zu mindestens einem Anschlussabschnitt zwischen mindestens einem der Kontaktpunkte der Menge von Kontaktpunkten und der gedruckten Schaltung von außerhalb des Lesers verhindert.

2. Speicherkartenleser nach Anspruch 1, **dadurch gekennzeichnet, dass** die Vorrichtung zum Schutz gegen Eindringen im Wesentlichen die Form eines rechteckigen Parallelepipeds aufweist, das auf seiner Oberseite einen Vorsprung (14.1) zur Behinderung des Zugangs zu den Kontaktpunkten vom Oberteil der Vorrichtung zum Schutz gegen Eindringen umfasst.

3. Speicherkartenleser nach Anspruch 1, **dadurch gekennzeichnet, dass** die Vorrichtung zum Schutz gegen Eindringen mindestens eine dreidimensionale Leiterschaltung und mindestens zwei Kontaktelemente der Leiterschaltung mit einem Bereich zum Anschluss der Vorrichtung zum Schutz gegen Eindringen auf der gedruckten Schaltung umfasst.

4. Speicherkartenleser nach Anspruch 1, **dadurch gekennzeichnet, dass** die gedruckte Schaltung eine Zone umfasst, die dazu bestimmt ist, die Vorrichtung zum Schutz gegen Eindringen aufzunehmen, und die eine gerade Anzahl von Bereichen zum Anschluss der Vorrichtung zum Schutz gegen Eindringen umfasst.

5. Speicherkartenleser nach Anspruch 4, **dadurch gekennzeichnet, dass** die Bereiche aus mindestens zwei durch einen Raum getrennten Abschnitten aufgebaut sind, der bei der Befestigung der Vorrichtung zum Schutz gegen Eindringen auf der gedruckten Schaltung den aus der Befestigung resultierenden Austritt von Luft ermöglicht.

6. Geheimcode-Eingabevorrichtung, **dadurch gekennzeichnet, dass** sie einen Speicherkartenleser nach Anspruch 1 umfasst.

7. Vorrichtung zum Schutz gegen Eindringen für Speicherkartenleser nach einem der Ansprüche 1 bis 6, **dadurch gekennzeichnet, dass** sie mehrere übereinander liegende und mittels vergrabener Durchkontaktierungen untereinander verbundene Schichten von gedruckten Schaltungen umfasst und dass sie die Form einer elektronischen Komponente aufweist, die dazu geeignet ist, elektrisch mit einer gedruckten Schaltung verbunden zu werden, auf der sie befestigt wird.

8. Verfahren zur Sicherung einer elektronischen Komponente, die auf einer gedruckten Schaltung angebracht ist, **dadurch gekennzeichnet, dass** es einen Schritt der Befestigung einer Vorrichtung zum Schutz gegen Eindringen nach Anspruch 7, die mehrere übereinander liegende und mittels vergrabener Durchkontaktierungen untereinander verbundene Schichten von gedruckten Schaltungen umfasst und geeignet ist, mit einer gedruckten Schaltung, auf der sie befestigt wird, elektrisch verbunden zu werden, und der zu sichernden elektronischen Komponente aneinander umfasst.
